(19) 

Europäisches
Patentamt
European
Patent Office
Office européen
des brevets

(11) **EP 4 023 362 A1**

(12) **EUROPEAN PATENT APPLICATION**
published in accordance with Art. 153(4) EPC

(43) Date of publication:
06.07.2022 Bulletin 2022/27

(21) Application number: 20868602.2

(22) Date of filing: 18.09.2020

(51) International Patent Classification (IPC):
B22F 1/00 (2022.01)   B22F 7/08 (2006.01)
B82Y 30/00 (2011.01)   B82Y 40/00 (2011.01)
H01B 1/22 (2006.01)   B22F 1/052 (2022.01)
B22F 1/0545 (2022.01)   B22F 1/054 (2022.01)
B22F 1/068 (2022.01)   B22F 1/107 (2022.01)
B22F 1/145 (2022.01)   B22F 7/06 (2006.01)
C22C 1/04 (2006.01)   B22F 7/04 (2006.01)

(52) Cooperative Patent Classification (CPC):
B22F 1/052; B22F 1/0545; B22F 1/056;
B22F 1/068; B22F 1/09; B22F 1/107; B22F 1/147;
B22F 7/062; B22F 7/08; B82Y 30/00; B82Y 40/00;
C22C 1/0425; H01B 1/22; B22F 2007/047;
H01L 2224/13082;                          (Cont.)

(86) International application number:
PCT/JP2020/035564

(87) International publication number:
WO 2021/060204 (01.04.2021 Gazette 2021/13)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 25.09.2019 JP 2019174073

(71) Applicant: Showa Denko Materials Co., Ltd.
Tokyo 100-6606 (JP)

(72) Inventors:
• YANAKA, Yuichi
Chiyoda-ku, Tokyo 100-6606 (JP)

• NAKAKO, Hideo
Tokyo 100-6606 (JP)
• KAWANA, Yuki
Tokyo 100-6606 (JP)
• NEGISHI, Motohiro
Tokyo 100-6606 (JP)
• SUGAMA, Chie
Tokyo 100-6606 (JP)
• EJIRI, Yoshinori
Chiyoda-ku, Tokyo 100-6606 (JP)

(74) Representative: Beckmann, Claus
Kraus & Weisert
Patentanwälte PartGmbB
Thomas-Wimmer-Ring 15
80539 München (DE)

(54) **COPPER PASTE FOR FORMING SINTERED COPPER PILLAR AND METHOD FOR PRODUCING BONDED BODY**

(57) Provided is copper paste for forming a sintered copper pillar that bonds members to each other, the copper paste contains metal particles, and an organic dispersion medium, the metal particles including copper particles, and the organic dispersion medium containing a high-boiling-point solvent having a boiling point of 280°C or higher in an amount of 50% by mass to 99% by mass on the basis of a total mass of the organic dispersion medium.

**(Cont. next page)**

EP 4 023 362 A1

*Fig.1*

(52) Cooperative Patent Classification (CPC): (Cont.)
H01L 2224/13347; H01L 2224/16145;
H01L 2224/32245; H01L 2224/40245;
H01L 2224/48091

## Description

## Technical Field

The present invention relates to copper paste for forming sintered copper pillar and a method for producing a bonded body.

## Background Art

Solder bonding is typically used for electrical bonding in electronic devices. For example, in flip-chip bonding of a micro device, a solder ball, solder paste, or the like is used for bonding between the micro device and an electrode pad on a substrate.

In recent, in the flip-chip bonding, along with narrowing of a terminal pitch, a method in which a metal pillar is formed on the micro device, and the metal pillar and the electrode pad on the substrate is solder-bonded has been used. However, in the solder bonding, there are problems such as (1) Kirkendall voids occur between the solder and the electrode pad and between the solder and the metal pillar, (2) in a case where a reflow process is performed again after bonding, the solder is melted and a bonding failure occurs, and (3) signal reflection occurs due to impedance mismatching at an interface between different metals.

In contrast, a method of performing bonding by using a metal other than the solder has been examined. For example, Patent Literature 1 suggests a method of bonding the copper pillar provided on the micro device and the copper pad on the substrate by using adhesive (copper paste) obtained by mixing copper micro particles and copper nano particles.

## Citation List

## Patent Literature

Patent Literature 1: U.S. Patent Application Publication No. 2016/0351529

## Summary of Invention

## Technical Problem

In the method disclosed in Patent Literature 1, it is necessary to form the copper pillar on the device in advance, but in a formation method by electrolytic plating which is the mainstream method of forming the copper pillar, there is a problem that it takes time to form the pillar. In addition, there is a problem that when a plating rate is increased, a height variation becomes large.

Here, the present inventors have examined a method in which a pillar precursor is formed between members to be bonded by using copper paste containing copper particles and an organic dispersion medium, and the pillar precursor is sintered, thereby forming a sintered copper pillar and bonding the members to be bonded. According to the method, the sintered copper pillar can be formed efficiently with accuracy. However, as a result of examination made by the present inventors, in a case where long time (for example, approximately 1 to 3 hours) is taken from formation of the pillar precursor and mounting of the members to be bonded, it is apparent that bonding between the pillar and the members to be bonded may be insufficient.

The invention has been made in consideration of such circumstances, and an object thereof is to provide copper paste for forming a sintered copper pillar capable of stably forming a bonded body bonded by the sintered copper pillar even in a case of performing mounting of a member to be bonded and sintering after a pillar precursor is left for a long time, and a method for producing a bonded body by using the copper paste.

## Solution to Problem

According to an aspect of the invention, there is provided copper paste for forming a sintered copper pillar that bonds members to each other, the copper paste containing metal particles, and an organic dispersion medium, the metal particles including copper particles, and the organic dispersion medium containing a high-boiling-point solvent having a boiling point of 280°C or higher in an amount of 50% by mass to 99% by mass on the basis of a total mass of the organic dispersion medium.

According to the above aspect copper paste, even in a case of performing mounting of a member to be bonded and sintering after a pillar precursor is left for a long time (for example, approximately 1 to 3 hours), a bonded body bonded by the sintered copper pillar can be stably formed.

The amount of the high-boiling-point solvent is preferably 5% by mass to 30% by mass on the basis of the total mass of the copper paste.

The organic dispersion medium may include two or more kinds of the high-boiling-point solvents.

The copper paste preferably includes at least one kind selected from the group consisting of isobornyl cyclohexanol and butyl stearate as the high-boiling-point solvent.

According to another aspect of the invention, there is provided a method for producing a bonded body including a first member, a second member, and a sintered copper pillar that bonds the first member and the second member to each other, the method including steps of molding the above aspect copper paste in a pillar shape on the first member, and then mounting the second member to provide a pillar precursor between the first member and the second member; and sintering the pillar precursor to form the sintered copper pillar.

According to the above aspect method for producing a bonded body, since a time delay of approximately 1 to 3 hours can be provided from formation of the pillar precursor to mounting of a member to be bonded, the bonded body can be produced in a simple and stable manner.

**Advantageous Effects of Invention**

According to the invention, it is possible to provide copper paste for forming a sintered copper pillar capable of stably forming a bonded body bonded by the sintered copper pillar even in a case of performing mounting of a member to be bonded and sintering after a pillar precursor is left for a long time, and a method for producing a bonded body by using the copper paste.

**Brief Description of Drawings**

FIG. 1 is a schematic cross-sectional view illustrating an embodiment of a bonded body according to the invention.
FIG. 2 is a schematic cross-sectional view illustrating an embodiment of a method for producing the bonded body according to the invention.
FIG. 3 is a schematic cross-sectional view illustrating an embodiment of the method for producing the bonded body according to the invention.
FIG. 4 is a schematic cross-sectional view illustrating an embodiment of the method for producing the bonded body according to the invention.
FIG. 5 is a schematic cross-sectional view illustrating an embodiment of a bonding pillar equipped member according to the invention.

**Description of Embodiments**

Hereinafter, embodiments for carrying out the invention will be described in detail. However, the invention is not limited to the following embodiments. In the following embodiments, constituent elements (including element steps and the like) are not essential except for a case the constituent elements are considered to be essential in principle when being clearly disclosed, and the like. This is also true of numerical values and ranges thereof, and thus the invention is not limited.

In this specification, with regard to a term of "step", not only an independent step but also a step that is not clearly distinguished from another step is included in the term as long as the purpose of the step is accomplished. In this specification, a numerical range expressed by using "to" represents a range including numerical values before and after "to" as a minimum value and a maximum value. With regard to the amount of each component in a composition in this specification, in a case where a plurality of substances corresponding to each component in the composition exists, the amount represents a total amount of the plurality of kinds of substances existing in the composition unless otherwise stated. In this specification, a "boiling point" represents a boiling point at 1 atm.

<Bonded Body>

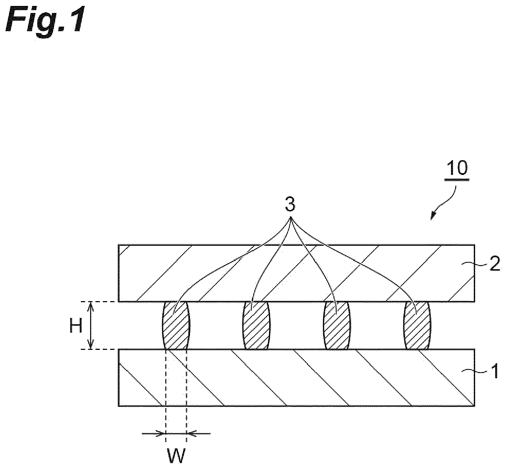

FIG. 1 is a schematic cross-sectional view illustrating an embodiment of a bonded body according to the invention. A bonded body 10 illustrated in FIG. 1 includes a first member 1, a second member 2, and a sintered copper pillar 3 that bonds the first member 1 and the second member 2 to each other.

A lower surface and an upper surface of the sintered copper pillar each constitute a bonding surface with the first member and a bonding surface with the second member, and both are bonded by a metal bond. Since such a metal bond is formed, the bonded body can be firmly bonded with low electrical resistance.

Examples of the first member 1 and the second member 2 include an active or passive electronic device, a wiring board on which an electronic device is mounted, a package including an electronic device and a re-wiring layer provided on the electronic device, and the like.

Examples of the electronic device include a coil, a capacitor, a SAW filter, a power IC, a logic chip, a memory chip, a sensor, a piezoelectric element, a transistor, and a diode.

Examples of the wiring board include a mounting substrate, a lead frame such as a copper lead frame, a ceramic substrate, a resin molded product including a printed metal interconnection such as a molded interconnect device (MID, molded circuit part), and a package including a re-wiring layer.

One of the first member and the second member may be active or passive electronic devices, and the other may be a wiring board on which the electronic device is to be mounted. In this case, electronic device mounting excellent in reliability can be realized.

In addition, both the first member and the second member may be a package including an electronic device and a re-wiring layer provided on the electronic device. In this case, package-on-package mounting excellent in reliability can be realized.

The first member and/or the second member may contain one or more kinds of metals selected from the group consisting of copper, nickel, silver, platinum, gold, and palladium on a bonding surface with the sintered copper pillar. The metals can reduce and remove an oxide film on a surface at a sintering temperature of 300°C or lower under a reducing atmosphere such as hydrogen and formic acid. Accordingly, the bonded body can have high bonding strength due to metal bonding between an exposed metal surface of the member and the sintered copper pillar. The metals may be provided on the first member and/or the second member as a metal film or a sintered metal layer.

The amount of copper in the sintered copper pillar is preferably 96% by mass or more on the basis of a total mass of components (provided that, carbon, oxygen, and nitrogen are excluded) which constitute the sintered copper pillar, more preferably 96.5% by mass or more, and still more preferably 97% by mass or more. Note that, carbon, oxygen, and nitrogen are components which may be randomly contained in the sintered copper pillar due to filling of underfill by mounting or filling of a sealing material.

When the amount of copper in the sintered copper pillar is within the above-described range, formation of the sintered copper pillar through printing and sintering of the copper paste for forming the sintered copper pillar to be described later becomes easy, and there is an advantage from the viewpoint of securement of bonding strength and suppression of electromigration. In addition, in a case where a bonding surface contains copper, since bonding by the same kinds of metals occurs, it is easy to suppress occurrence of Kirkendall voids, and a bonded body that is more excellent in connection reliability is realized.

From the viewpoints of thermal conductivity and electrical conductivity, a volume ratio of copper in the sintered copper pillar is preferably 50% by volume or more, more preferably 60% by volume or more, and still more preferably 70% by volume or more. The larger the volume ratio of copper in the sintered copper pillar is, the higher the thermal conductivity and the electrical conductivity of the sintered copper pillar become, and thus this case is preferable. Note that, in this specification, a portion other than copper in the sintered copper pillar is expressed as voids. However, in a case where a resin component such as a filling material and an underfill is included in the voids, a volume of the component is also included as the volume of the voids. The volume ratio of copper in the sintered copper pillar can be obtained from a SEM image of a cross-section of the sintered copper pillar.

In the sintered copper pillar, a shortest distance H between the bonding surface with the first member and the bonding surface with the second member (may be referred to as "height of the sintered copper pillar") may be 5 to 200 $\mu$m, 10 to 150 $\mu$m, or 20 to 100 $\mu$m.

A minimum diameter W in a cross-section orthogonal to a pillar extending direction in the sintered copper pillar (may be referred to as "width (diameter) of the sintered copper pillar") may be 10 to 500 $\mu$m, 25 to 300 $\mu$m, or 50 to 150 $\mu$m.

In the sintered copper pillar, a ratio (H/W) between H and W (may be referred to as "cross-section aspect ratio of the sintered copper pillar") may be 0.01 to 4.0, 0.1 to 2.5, or 0.15 to 2.0.

H and W can be obtained from the SEM image of the cross-section of the sintered copper pillar.

In the bonded body of this embodiment, shear strength between the bonding surfaces of the first member and/or the second member and the sintered copper pillar may be 4 MPa or more, 10 MPa or more, or 20 MPa or more. At this time, the bonding surfaces of the first member and/or the second member can have the above-described metals, and may include the above-described metals as a metal layer.

For example, the shear strength can be calculated by dividing the maximum strength when the sintered copper pillar is pressed in a horizontal direction at a constant speed by a tool of a bonding strength test device that is used, and the bonding surface between the sintered copper pillar and the member is peeled off by a cross-sectional area of the pillar.

<Method for Producing Bonded Body>

A method for producing a bonded body of this embodiment is a method for producing the bonded body according to the above-described embodiment, and includes a step of forming the sintered copper pillar by sintering a pillar precursor disposed between the first member and the second member. The pillar precursor contains metal particles and an organic dispersion medium, and the metal particles can include copper particles.

In this embodiment, the pillar precursor can be provided between the first member and the second member by molding the copper paste (copper paste for forming the sintered copper pillar) on the first member in a pillar shape, for example, through printing, and by mounting the second member on the copper paste.

[Copper Paste for Forming Sintered Copper Pillar]

The copper paste for forming the sintered copper pillar according to this embodiment contains metal particles and an organic dispersion medium, and the metal particles include copper particles.

Examples of the copper particles include sub-micro copper particles and micro copper particles. The sub-micro copper particles represent copper particles having a particle size of 0.01 $\mu$m or more and less than 0.8 $\mu$m. The micro copper particles represent copper particles having a particle size of 0.8 to 50 $\mu$m.

The copper paste of this embodiment preferably contains sub-micro copper particles from the viewpoint of easily securing bonding strength and connection reliability. The copper paste may further contain other metal particles other than the micro copper particles and/or the copper particles as necessary.

(Sub-Mirco Copper Particles)

As the sub-micro copper particles, copper particles having sinterability in a temperature range of 150°C to 300°C can be used. Examples of the sub-micro copper particles include copper particles including copper particles having a particle size of 0.01 $\mu$m or more and less than 0.8 $\mu$m, and for example, copper particles having a volume average particle size of 0.01 $\mu$m or more and less than 0.8 $\mu$m can be used. When the volume average particle size of the sub-micro copper particles is 0.01 $\mu$m or more, effects such as a reduction in the synthesis cost for the sub-micro copper particles, satisfactory dispersibility, and a reduction in the amount of a surface treatment agent that is used are likely to be obtained. When the volume average particle size of the sub-micro copper particles is less than 0.8 $\mu$m, an effect such as excellent sinterability of the sub-micro copper particles is likely to be obtained. From the viewpoint of further obtaining the above-described effect, the upper limit of the volume average particle size of the sub-micro copper particles may be 0.6 $\mu$m or less, 0.5 $\mu$m or less, or 0.4 $\mu$m or less. In addition, the lower limit of the volume average particle size of the sub-micro copper particles may be 0.02 $\mu$m or more, 0.05 $\mu$m or more, or 0.1 $\mu$m or more. For example, the volume average particle size of the sub-micro copper particles may be 0.01 to 0.5 $\mu$m, 0.12 $\mu$m or more and less than 0.8 $\mu$m, 0.15 $\mu$m or more and less than 0.8 $\mu$m, 0.15 to 0.6 $\mu$m, 0.2 to 0.5 $\mu$m, or 0.3 to 0.45 $\mu$m.

Note that, the volume average particle size in this specification represents 50% volume average particle size. When obtaining the volume average particle size of the copper particles, the volume average particle size can be obtained by a method in which dried copper particles obtained by removing volatile components from copper particles as a raw material, or copper paste are dispersed in a dispersion medium by using a dispersant, and the volume average particle size of the resultant dispersion product is measured with a light scattering particle size distribution measuring device (for example, Shimadzu nano particle size distribution measuring device (SALD-7500nano, manufactured by SHIMADZU CORPORATION)), or the like. In a case of using the light scattering particle size distribution measuring device, hexane, toluene, $\alpha$-terpineol, 4-methyl-1,3-dioxolane-2-one, or the like can be used as the dispersion medium.

A shape of the sub-micro copper particles is not particularly limited. For example, the sub-micro copper particles may have a spherical shape, a lump shape, a needle shape, a columnar shape, a flake shape, or an approximately spherical shape, or may be an aggregate of particles having these shapes. The shape of the sub-micro copper particles may be the spherical shape, the approximately spherical shape, or the flake shape from the viewpoint of dispersibility and filling properties, or may be the spherical shape or the approximately spherical shape from the viewpoint of combustibility, dispersibility, mixing properties with flake-shaped micro particles, and the like. In this specification, the "flake shape" includes a flat plate shape such as a plate shape and scale shape.

An aspect ratio of the sub-micro copper particles may be 5 or less, 4 or less, or 3 or less from the viewpoints of dispersibility, filling properties, and mixability with the flake-shaped micro particles. In this specification, an "aspect ratio of particles" (for example, an aspect ratio of the sub-micro copper particles) represents long side/thickness of particles (for example, the sub-micro copper particles). Measurement of the long side and the thickness of particles can be obtained, for example, from a SEM image of the particles.

The sub-micro copper particles may be treated by a specific surface treatment agent. Examples of the specific surface treatment agent include an organic acid having 2 to 18 carbon atoms (for example, an organic acid having an alkyl group having 1 to 17 carbon atoms). Examples of the organic acid having 2 to 18 carbon atoms include saturated fatty acids such as acetic acid, propanoic acid, butanoic acid, pentanoic acid, hexanoic acid, heptanoic acid, caprylic acid, methylheptanoic acid, ethylhexanoic acid, propylpentanoic acid, pelargonic acid, methyloctanoic acid, ethylheptanoic acid, propylhexanoic acid, capric acid, methylnonanoic acid, ethyloctanoic acid, propylheptanoic acid, butylhexanoic acid, undecanoic acid, methyldecanoic acid, ethylnonanoic acid, propyloctanoic acid, butylheptanoic acid, lauric acid, methylundecanoic acid, ethyldecanoic acid, propylnonanoic acid, butyloctanoic acid, pentylheptanoic acid, tridecanoic acid, methyldodecanoic acid, ethylundecanoic acid, propyldecanoic acid, butylnonanoic acid, pentyloctanoic acid, myristic acid, methyltridecanoic acid, ethyldodecanoic acid, propylundecanoic acid, butyldecanoic acid, pentylnonanoic acid, hexyloctanoic acid, pentadecanoic acid, methyltetradecanoic acid, ethyltridecanoic acid, propyldodecanoic acid, butylundecanoic acid, pentyldecanoic acid, hexylnonanoic acid, palmitic acid, methylpentadecanoic acid, ethyltetradecanoic acid, propyltridecanoic acid, butyldodecanoic acid, pentylundecanoic acid, hexyldecanoic acid, heptylnonanoic acid, heptadecanoic acid, octadecanoic acid, methylcyclohexanecarboxylic acid, ethylcyclohexanecarboxylic acid, propylcyclohexanecarboxylic acid, butylcyclohexanecarboxylic acid, pentylcyclohexanecarboxylic acid, hexylcyclohexanecarboxylic acid, heptylcyclohexanecarboxylic acid, octylcyclohexanecarboxylic acid, and nonylcyclohexanecarboxylic acid; unsaturated fatty acids such as octenoic acid, nonenoic acid, methylnonenoic acid, decenoic acid, undecenoic acid, dodecenoic acid, tridecenoic acid, tetradecenoic acid, myristoleic acid, pentadecenoic acid, hexadecenoic acid, palmitoleic acid, sapienic acid, oleic acid, vaccenic acid, linolic acid, linoleic acid, and linolenic acid; aromatic carboxylic acids such as terephthalic acid, pyromellitic acid, o-phenoxybenzoic acid, methylbenzoic acid, ethylbenzoic acid, propylbenzoic acid, butylbenzoic acid, pentylbenzoic acid, hexylbenzoic acid, heptylbenzoic acid, octylbenzoic acid, and nonylbenzoic acid. The organic acid may be used alone or two or more kinds thereof may be used in combination. When combining the organic acid and the sub-micro copper particles, there is a tendency that dispersibility of the sub-micro copper particles, and a desorption property of the organic acid at the time of sintering are compatible with each other.

A treatment amount of the surface treatment agent may be 0.07% by mass to 2.1% by mass, 0.10% by mass to 1.6% by mass, or 0.2% by mass to 1.1% by mass.

As the sub-micro copper particles, commercially available sub-micro copper particles can be used. Examples of the commercially available sub-micro copper particles include CH-0200 (manufactured by Mitsui Mining & Smelting Co., Ltd., volume average particle size: 0.36 $\mu$m), HT-14 (manufactured by Mitsui Mining & Smelting Co., Ltd., volume average particle size: 0.41 $\mu$m), CT-500 (manufactured by Mitsui Mining & Smelting Co., Ltd., volume average particle size: 0.72 $\mu$m), Tn-Cu100 (manufactured by Taiyo Nippon Sanso Corporation, volume average particle size: 0.12 $\mu$m), and Cu-C-40 (manufactured by Fukuda Metal Foil & Powder Co., Ltd., volume average particle size: 0.2 $\mu$m).

The content of the sub-micro copper particles may be 30% by mass or more, 40% by mass or more, 50% by mass or more, or 60% by mass or more on the basis of the total mass of the metal particles, and may be 100% by mass or less, 95% by mass or less, 90% by mass or less, or 80% by mass or less on the basis of the total mass of the metal particles. The content of the sub-micro copper particles may be 30% by mass to 100% by mass, 40% by mass to 90% by mass, 50% by mass to 95% by mass, 50% by mass to 80% by mass, 60% by mass to 80% by mass, or 60% by mass to 90% by mass on the basis of the total mass of the metal particles. When the content of the sub-micro copper particles is within the above-described ranges, it is easy to secure bonding strength of a bonded body obtained by sintering a pillar precursor formed by copper paste, and in a case where a member of the bonded body is a micro device, the micro device tends to exhibit satisfactory die shear strength and connection reliability.

The content of the sub-micro copper particles may be 20% by mass to 95% by mass, 30% by mass to 85% by mass, or 40% by mass to 75% by mass on the basis of the total mass of copper paste from the viewpoint of promotion of sintering, satisfactory connection between the first member and the second member, and exhibition of low-temperature sinterability.

(Micro Copper Particles)

As the micro copper particles, copper particles having a particle size of 0.8 to 50 $\mu$m can be used, and for example, copper particles having a volume average particle size of 0.8 to 50 $\mu$m can be used.

The micro copper particles are preferably blended with the sub-micro copper particles in combination. In this case, it is possible to reduce volume shrinkage, occurrence of voids, and the like when sintering the pillar precursor formed by copper paste, it is easy to secure bonding strength of the bonded body obtained by sintering the pillar precursor, and in a case where a member of the bonded body is a micro device, the micro device tends to exhibit satisfactory die shear strength and connection reliability. From the viewpoint of further obtaining the above-described effects, the volume average particle size of the micro copper particles may be 0.8 to 20 $\mu$m, 0.8 to 10 $\mu$m, 2 to 20 $\mu$m, 2 to 10 $\mu$m, 3 to 20 $\mu$m, or 3 to 10 $\mu$m.

A shape of the micro copper particles is not particularly limited. For example, the micro copper particles may have a spherical shape, a lump shape, a needle shape, a flake shape, or an approximately spherical shape, or may be an aggregate of particles having these shapes.

In this embodiment, the flake-shaped micro copper particles may be blended with the sub-micro copper particles in combination. In this case, since the micro copper particles in the pillar precursor are oriented approximately in parallel with respect to a bonding surface, volume shrinkage in a bonding surface direction when sintering the pillar precursor can be suppressed, it is easy to secure bonding strength of a bonded body obtained by sintering the pillar precursor. In a case where a member of the bonded body is a micro device, the micro device tends to exhibit satisfactory die shear strength and connection reliability. From the viewpoint of further obtaining the above-described effects, an aspect ratio of the flake-shaped micro copper particles is preferably 3 or more, more preferably 4 or more, and still more preferably 6 or more.

In the micro copper particles, presence or absence of the treatment by the surface treatment agent is not particularly limited. From the viewpoint of dispersion stability and oxidation resistance, the micro copper particles may be treated by the surface treatment agent. The surface treatment agent may be removed at the time of bonding. Examples of the surface treatment agent include aliphatic carboxylic acid such as dodecanoic acid, palmitic acid, heptadecanoic acid, stearic acid, arachidic acid, linolic acid, linoleic acid, and oleic acid; aromatic carboxylic acids such as terephthalic acid, pyromellitic acid, o-phenoxybenzoic acid; aliphatic alcohols such as cetyl alcohol, stearyl alcohol, isobornyl cyclohexanol, and tetraethylene glycol; aromatic alcohols such as p-phenylphenol; alkylamines such as octylamine, dodecylamine, and stearylamine; aliphatic nitriles such as stearonitrile and decanenitrile; silane coupling agents such as alkylalkoxysilane; and polymer treatment agents such as polyethylene glycol, polyvinyl alcohol, polyvinylpyrrolidone, and silicone oligomer. The surface treatment agents may be used alone or two or more kinds thereof may be used in combination.

As the micro copper particles, micro copper particles commercially available can be used. Examples of the commercially available flake-shaped micro copper particles include MA-C025KFD (manufactured by Mitsui Mining & Smelting Co., Ltd., volume average particle size: 7.5 $\mu$m), 4L3N (manufactured by Fukuda Metal Foil & Powder Co., Ltd., volume average particle size: 3.0 $\mu$m), 3L3N (manufactured by Fukuda Metal Foil & Powder Co., Ltd., volume average particle size: 5.7 $\mu$m), 3L3 (manufactured by Fukuda Metal Foil & Powder Co., Ltd., volume average particle size: 8.0 $\mu$m), 2L3N (manufactured by Fukuda Metal Foil & Powder Co., Ltd., volume average particle size: 9.9 $\mu$m), 1110F (manufactured by Mitsui Mining & Smelting Co., Ltd., volume average particle size: 3.8 $\mu$m), 1050YP (manufactured by Mitsui Mining & Smelting Co., Ltd., volume average particle size: 0.94 $\mu$m), 1100YP (manufactured by Mitsui Mining & Smelting Co., Ltd., volume average particle size: 1.2 $\mu$m), 1200YP (manufactured by Mitsui Mining & Smelting Co., Ltd., volume average particle size: 3.4 $\mu$m), and 1400YP (manufactured by Mitsui Mining & Smelting Co., Ltd., volume average particle size: 5.2 $\mu$m).

Examples of spherical or approximately spherical micro copper particles include 1050Y (manufactured by Mitsui Mining & Smelting Co., Ltd., volume average particle size: 0.81 $\mu$m), 1100Y (manufactured by Mitsui Mining & Smelting Co., Ltd., volume average particle size: 1.1 $\mu$m), 1200Y (manufactured by Mitsui Mining & Smelting Co., Ltd., volume average particle size: 2.1 $\mu$m), 1300Y (manufactured by Mitsui Mining & Smelting Co., Ltd., volume average particle size: 4.6 $\mu$m), 1400Y (manufactured by Mitsui Mining & Smelting Co., Ltd., volume average particle size: 5.5 $\mu$m), 1200YM (manufactured by Mitsui Mining & Smelting Co., Ltd., volume average particle size: 1.9 $\mu$m), 1300YM (manufactured by Mitsui Mining & Smelting Co., Ltd., volume average particle size: 3.4 $\mu$m), 1400YM (manufactured by Mitsui Mining & Smelting Co., Ltd., volume average particle size: 4.2 $\mu$m), Cu-HWQ 1.5 $\mu$m (manufactured by Fukuda Metal Foil & Powder Co., Ltd., volume average particle size: 1.5 $\mu$m), Cu-HWQ 1.5 $\mu$m (manufactured by Fukuda Metal Foil & Powder Co., Ltd., volume average particle size: 1.4 $\mu$m), Cu-HWQ 3.0 $\mu$m (manufactured by Fukuda Metal Foil & Powder Co., Ltd., volume average particle size: 3.0 $\mu$m), Cu-HWQ 5.0 $\mu$m (manufactured by Fukuda Metal Foil & Powder Co., Ltd., volume average particle size: 4.1 $\mu$m), and Cu-HWQ 10 $\mu$m (manufactured by Fukuda Metal Foil & Powder Co., Ltd., volume average particle size: 9.4 $\mu$m).

The content of the micro copper particles may be 0% by mass or more, more than 0% by mass, or 5% by mass to 10% by mass, and 70% by mass or less, 50% by mass or less, or 40% by mass or less on the basis of the total mass of the metal particles. The content of the micro copper particles is preferably 0% by mass to 70% by mass on the basis of the total mass of the metal particles, more preferably more than 0% by mass and 70% by mass or less, still more preferably 5% by mass to 50% by mass, and particularly preferably 10% by mass to 40% by mass.

The copper paste in this embodiment can contain micro copper particles having a volume average particle size of 0.8 to 50 $\mu$m, and preferably micro copper particles having a volume average particle size of 2 to 50 $\mu$m on the basis of the total mass of the metal particles in a ratio of more than 0% by mass and 50% by mass or less. In this case, it is possible to reduce volume shrinkage, occurrence of voids, and the like when sintering the copper paste molded in a pillar shape, and it is easy to secure bonding strength of a bonded body that is bonded by the sintered copper pillar.

In a case of blending the flake-shaped micro copper particles, the content of the flake-shaped micro copper particles is preferably 0% by mass to 70% by mass on the basis of the total mass of the metal particles, more preferably 5% by mass to 50% by mass, and still more preferably 10% by mass to 40% by mass from the viewpoint of effectively obtaining the above-described effects, and particularly preferably 20% by mass to 40% by mass from the viewpoint of sufficiently securing the strength of the sintered copper pillar and suppressing occurrence of cracks while suppressing a deviation in height of the pillar precursor.

The copper paste in this embodiment may contain copper nano particles within a range not deteriorating the effect due to the micro copper particles and the sub-micro copper particles. The copper nano particles represent copper particles having a particle size of less than 0.01 μm. From the viewpoint of making the sintered copper pillar denser and improving the copper content, the content of the copper nano particles is preferably 30% by mass or less on the basis of the total mass of the metal particles, more preferably 15% by mass or less, still more preferably 5% by mass or less, particularly preferably 1% by mass or less, and it is extremely preferable that the content is 0% by mass, that is, the copper nano particles are not contained.

(Other Metal Particles Other Than Copper Particles)

The metal particles may include other metal particles other than copper particles such as the sub-micro copper particles and the micro copper particles, and the metal particles may include particles of zinc, nickel, silver, gold, palladium, platinum, or the like. A volume average particle size of the other metal particles other than the copper particles may be 0.01 to 10 μm, 0.01 to 5 μm, or 0.05 to 3 μm. In a case where the metal particles include the other metal particles, the content thereof may be less than 20% by mass, 10% by mass or less, 5% by mass or less, 1% by mass or less on the basis of the total mass of the metal particles from the viewpoint of obtaining sufficient bonding properties. The metal particles may not include the other metal particles. A shape of the other metal particles is not particularly limited.

The content of the other metal particles may be 1% by mass or more or 5% by mass or more on the basis of the total mass of the metal particles. In a case where the copper paste contains the metal particles other than the copper particles, particularly, in a case where the copper paste contains metal particles having metal species having a low melting point, a sintering temperature can be lowered. In addition, since a sintered body in which a plurality of kinds of metals are dissolved or dispersed can be obtained, mechanical characteristics such as a yield stress and fatigue strength of the sintered body are improved, and thus connection reliability is likely to be improved. In addition, since the plurality of kinds of metal particles are added, the sintered body can have sufficient bonding strength with respect to a specific adherend. In a case where a member of the bonded body is a micro device, die shear strength and connection reliability of the micro device are likely to be improved.

(Organic Dispersion Medium)

The organic dispersion medium includes a solvent having a boiling point lower than 280°C (hereinafter, also referred to as "low-boiling-point solvent") and a solvent having a boiling point of 280°C or higher (hereinafter, also referred to as "high-boiling-point solvent"). In this embodiment, the content of the high-boiling-point solvent is 50% by mass to 99% by mass on the basis of the total mass of the organic dispersion medium. When using the organic dispersion medium, it is possible to stably form a bonded body bonded by the sintered copper pillar even in a case of performing mounting of a member to be bonded and sintering after a pillar precursor is left for a long time. The reason why this effect is obtained is not clear, but the present inventors presume that the kind and the amount of the organic dispersion medium in the pillar precursor have an influence on formation of a stable sintered copper pillar. That is, in the invention, it is considered that the amount of the high-boiling-point solvent contained in the pillar precursor is less likely to fluctuate from formation of the pillar precursor and mounting of the member to be bonded, and adhesiveness and flexibility are maintained due to a constant amount of high-boiling-point solvent that remains in the pillar precursor, and as a result, the above-described effect is obtained. In addition, since appropriate fluidity is obtained due to the low-boiling-point solvent, it is easy to mold the copper paste into a pillar shape.

As the low-boiling-point solvent, a solvent having a boiling point of 270°C or lower is preferable from the viewpoint of more efficiently forming a pillar with high accuracy, more preferably a solvent having a boiling point of 260°C or lower, and still more preferably a solvent having a boiling point of 250°C or lower. For example, the boiling point of the low-boiling-point solvent is 200°C or higher.

Examples of the low-boiling-point solvent include α-terpineol, diethylene glycol monobutyl ether, diethylene glycol monobutyl ether acetate, 4-methyl-1,3-dioxolan-2-one, and dihydroterpineol. The low-boiling-point solvent can be easily removed in a dry process, or a temperature-raising process before sintering the pillar precursor. Among these, α-terpineol and dihydroterpineol are preferable from the viewpoint of more efficiently molding the pillar with high accuracy in the following combination with the high-boiling-point solvent. The low-boiling-point solvents may be used alone, or a plurality of kinds thereof may be used in combination.

As the high-boiling-point solvent, a solvent having a boiling point of 290°C or higher is preferable, and a solvent having a boiling point of 300°C or higher is more preferable. Since the dispersion medium having the boiling point is likely to remain in the pillar precursor up to 150°C to 300°C as a firing temperature, adhesiveness and flexibility are more likely to be maintained. In addition, when using the dispersion medium having the boiling point, there is a tendency of further lengthening leaving time (time from formation of the pillar precursor to mounting of a member to be bonded) for which stable formation of bonding due to the sintered copper pillar becomes possible. On the other hand, as a solvent having a boiling point of 280°C or higher, a solvent having a boiling point of 450°C or lower is preferable, and a solvent having a boiling point of 400°C or lower is more preferable. The solvent is volatilized and excluded by a vapor pressure even at a temperature lower than the boiling point, but in a solvent having a boiling point higher than 450°C, a volatilization rate is excessively slow even at 150°C to 300°C as a sintering temperature, and thus sintering deterioration due to residual solvent is likely to occur.

As the high-boiling-point solvent, it is preferable to select a solvent having a structure in which affinity with metal particle surfaces is high so as to improve dispersibility of metal particles which are contained (for example, copper particles such as the sub-micro copper particles and the micro copper particles). For example, in a case where surfaces of the metal particles are treated with a surface treatment agent containing an alkyl group, it is preferable to select a solvent having the alkyl group. With regard to a combination of the surface treatment agent for the metal particles and the high-boiling-point solvent, it is preferable that the surface treatment agent is an organic acid including an alkyl group having 1 to 17 carbon atoms and the high-boiling-point solvent is a solvent including an alkyl group having 1 to 17 carbon atoms, it is more preferable that the surface treatment agent is an organic acid including an alkyl group having 5 to 17 carbon atoms and the high-boiling-point solvent is a solvent including an alkyl group having 5 to 17 carbon atoms, and it is still more preferable that the surface treatment agent is an organic acid including an alkyl group having 10 to 17 carbon atoms and the high-boiling-point solvent is a solvent including an alkyl group having 10 to 17 carbon atoms. According to the combination, even in a case of increasing the content of the high-boiling-point solvent, the metal particles can be dispersed in a satisfactory manner.

Examples of a specific high-boiling-point solvent include isobornyl cyclohexanol (Terusolve MTPH, manufactured by Nippon Terpene Chemicals, Inc.), butyl stearate (EXCEPARL BS, manufactured by Kao Corporation), stearyl stearate (EXCEPARL SS, manufactured by Kao Corporation), 2-ethylhexyl stearate (EXCEPARL EH-S, manufactured by Kao Corporation), isotridecyl stearate (EXCEPARL TD-S, manufactured by Kao Corporation), isooctadecanol (FINEOXOCOL 180 manufactured by Nissan Chemical Corporation, and FINEOXOCOL 180T manufactured by Nissan Chemical Corporation), 2-hexyldecanol (FINEOXOCOL 1600, manufactured by Nissan Chemical Corporation), tributyrin, tetraethylene glycol, heptadecane, octadecane, nonadecane, eikosane, heneikosane, docosane, methylheptadecane, tridecylcyclohexane, tetradecylcyclohexane, pentadecylcyclohexane, hexadecylcyclohexane, undecylbenzene, dodecylbenzene, tetradecylbenzene, tridecylbenzene, pentadecylbenzene, hexadecylbenzene, heptadecylbenzene, nonylnaphthalene, diphenylpropane, octyl octanoate, methyl myristate, ethyl myristate, methyl linoleate, methyl stearate, triethylene glycol bis(2-ethylhexanoate), tributyl citrate, pentyl phenol, dibutyl cebacate, oleyl alcohol, cetyl alcohol, methoxyphenethyl alcohol, benzyl phenol, hexadecanenitrile, heptadecanenitrile, benzyl benzoate, and cinmethylin. Among these, isobornyl cyclohexanol, isotridecyl stearate, octyl octanoate, 2-ethylhexyl stearate, and butyl stearate are preferred, isobornyl cyclohexanol, octyl octanoate, and butyl stearate are particularly preferred, and isobornyl cyclohexanol and butyl stearate are more preferred. The high-boiling-point solvents may be used alone or a plurality of kinds may be used in combination. In a case of using two or more kinds of the high-boiling-point solvents in combination, for example, in comparison to a case of using a high-boiling-point solvent having relatively high viscosity (isobornyl cyclohexanol, butyl stearate, or the like) alone, since a solvent having high viscosity is diluted by another solvent due to the combination of the solvents, viscosity of paste further decreases, and a plate release property and coating performance of paste are further improved. In addition, in a case of using butyl stearate (solidifying point: approximately 25°C) as one of the two or more kinds of high-boiling-point solvents, there is a tendency that a solidifying point is lowered, and solidification of paste is prevented. Particularly, it is preferable that isobornyl cyclohexanol is used in combination with tributyrin. In addition, it is preferable that butyl stearate is used in combination with octyl octanoate.

The content of the high-boiling-point solvent is 50% by mass or more on the basis of the total mass of the organic dispersion agent, and from the viewpoints that volatilization from the pillar precursor is less likely to occur and the high-boiling-point solvent is likely to remain in the pillar precursor up to sintering, the content is preferably 60% by mass or more, more preferably 70% by mass or more, still more preferably 80% by mass or more, and particularly preferably 90% by mass or more. The content of the high-boiling-point solvent is 99% by mass or less on the basis of the total mass of the organic dispersion medium, and from the viewpoints that copper paste is easily molded into a pillar shape with accuracy through printing, the content is preferably 98% by mass or less, and more preferably 97.5% by mass or less.

In a case of using isobornyl cyclohexanol as the high-boiling-point solvent, the content of isobornyl cyclohexanol is 10% by mass or more, 15% by mass or more, or 30% by mass or more, and 50% by mass or less, 45% by mass or less, or 30% by mass or less on the basis of the total mass of the organic dispersion medium. The content of isobornyl cyclohexanol may be 10% by mass to 50% by mass, 15% by mass to 45% by mass, or 20% by mass to 30% by mass on the basis of the total mass of the organic dispersion medium.

In a case of using butyl stearate as the high-boiling-point solvent, from the viewpoint that dispersibility of copper particles is improved, and from the viewpoint that butyl stearate is likely to remain in the pillar precursor up to sintering, the content of butyl stearate may be 20% by mass or more, 30% by mass or more, or 40% by mass or more on the basis of the mass of the organic dispersion medium. From the viewpoint that copper paste is easily molded into a pillar shape with accuracy through printing, the content of butyl stearate may be 70% by mass or less, 60% by mass or less, or 55% by mass or less on the basis of the mass of the organic dispersion medium. From the viewpoints, the content of butyl stearate may be 20% by mass to 70% by mass, 30% by mass to 60% by mass, or 40% by mass to 55% by mass on the basis of the mass of the organic dispersion medium.

The content of the high-boiling-point solvent is preferably 5% by mass or more on the basis of the total mass of the copper paste, more preferably 7% by mass or more, and 8% by mass or more. In this case, the amount of the high-boiling-point solvent in the pillar precursor is likely to be sufficient, and stable formation of a pillar tends to be easy. The content of the high-boiling-point solvent is preferably 30% by mass or less on the basis of the total mass of the copper paste, more preferably 25% by mass or less, and still more preferably 20% by mass or less. In this case, there is a tendency that it is easy to form the copper paste into a pillar shape with accuracy through printing. From the viewpoints, the content of the high-boiling-point solvent is preferably 5% by mass to 30% by mass on the basis of the total mass of the copper paste, more preferably 7% by mass to 25% by mass, and still more preferably 8% by mass to 20% by mass.

The content of the organic dispersion medium may be 5% by mass to 50% by mass on the basis of 100 parts by mass of metal particles. When the content of the organic dispersion medium is within the above-described range, the copper paste can be adjusted to have more appropriate viscosity, and sintering of copper particles is less likely to be deteriorated.

The kind of the organic dispersion medium contained in the copper paste can be analyzed, for example, by a gas chromatograph-mass analysis method of a high-temperature-desorption gas, and TOF-SIMS. Examples of other analysis methods include a method of identifying a supernatant, which is obtained by separating particle components through centrifugation, by typical organic analysis (for example, FT-IR, NMR, liquid chromatography, and a combination thereof). A ratio of types of the organic dispersion medium can be quantified by liquid chromatograph, NMR, or the like.

(Flexibility Imparting Component)

The copper paste of this embodiment can contain a flexibility imparting component. Examples of the flexibility imparting component include a thermally decomposable resin.

As the thermally decomposable resin, a non-crystalline polymer capable of exhibiting a bonding property or adhesiveness is preferable from the viewpoint of temporarily fixing an adherent and the pillar precursor up to firing after formation of the pillar precursor. In addition, it is preferable that the thermally decomposable resin also has a thermal decomposition property capable of being decomposed at a sintering temperature without a residue.

A thermal decomposition temperature of the thermally decomposable resin is preferably 300°C or lower, and more preferably 250°C or lower. Note that, the thermal decomposition temperature of the thermally decomposable resin is a decomposition initiation temperature of the thermally decomposable resin, and is set to 5% weight reduction temperature at TG/DTA measurement. However, the temperature represents a decomposition initiation temperature under a reducing atmosphere containing hydrogen, formic acid, or the like, or an inert gas atmosphere from which oxygen is removed instead of an oxidizing atmosphere such as the air.

The less the residue after thermal decomposition of the thermally decomposable resin, the more preferable because the residue hinders sintering of copper particles. The amount of the residue of the thermally decomposable resin after thermal decomposition is preferably 5% by mass or less with respect to the total mass of the resin before thermal decomposition, more preferably 3% by mass or less, and still more preferably 2% by mass or less. The amount of residue of the thermally decomposable resin after thermal decomposition can be measured as a weight variation amount after being retained for sintering time at a sintering temperature with TG/DTA for the thermal decomposable resin in an inert gas (nitrogen or argon) containing 3% by mass to 5% by mass of hydrogen. Note that, TG/DTA measurement in the air is not preferable because oxidative decomposition proceeds and thus the amount of residue becomes smaller than the amount of residue in a reducing atmosphere.

Note that, it is preferable that the thermally decomposable resin has dissolubility for the above-described organic dispersion medium. Examples of the thermally decomposable resin having the dissolubility for the organic dispersion medium and the above-described desired characteristics include polycarbonate, polymethacrylic acid, polymethacrylic acid ester, and polyester.

The content of the thermally decomposable resin in the copper paste may be 25% by mass or less, 15% by mass or less, 5% by mass or less, or 3% by mass or less on the basis of the total mass of the copper paste. The thermally decomposable resin may not be blended when the purpose is to form a sintered copper pillar. On the other hand, from the viewpoint of reducing the progress of drying by increasing a ratio of the flexibility imparting component contained in the entirety of solvent, the content of the thermally decomposable resin in the copper paste may be 5% by mass or more on the basis of the total mass of the copper paste.

The copper paste for forming the sintered copper pillar of this embodiment can be adjusted to have appropriate viscosity by a printing and applying method for forming the pillar precursor. The viscosity of the copper paste at 25°C may be 50 to 2000 Pa·s, 100 to 1750 Pa·s, or 200 to 1500 Pa·s. In a case where the viscosity of the copper paste is within the above-described range, it is easy to form the pillar precursor by various printing methods to be described later.

In this specification, the viscosity of the copper paste for forming the sintered copper pillar represents a value measured by an E-type viscometer at 25°C under a condition in which the number of revolutions is 0.5 rpm. As the E-type viscometer, for example, a product (manufactured by Toki Sangyo Co., Ltd., product name: VISCOMETER-TV33-type viscometer) can be used. As a measurement jig of a cone rotor, for example, 3° × R14, SPP is applicable.

A thixotropy index (hereinafter, also referred to as "TI value") of the copper paste for forming the sintered copper pillar of this embodiment may be 2.0 to 20, 3.0 to 15, or 4.0 to 10. If the TI value of the copper paste is within the range, since the viscosity of the copper paste is reduced due to a shear force, when performing agitation by manual work or an agitator (for example, a rotation and revolution type agitator (planetary vacuum mixer ARV-310, manufactured by Thinky Corporation) or the like) before printing, printing becomes easy, and viscosity of the copper paste restores when being left as is after adhering to a member that is an adherend, and excessive wetting and spreading of a printed matter can be suppressed.

In this specification, when viscosity measured by using the E-type viscometer at 25°C under a condition in which the number of revolutions is 0.5 rpm is $\mu_{0.5}$, and viscosity measured at 25°C under a condition in which the number of revolutions is 5 rpm is $\mu_5$, the TI value is set as a value calculated by the following expression.

$$TI \text{ value} = \mu_{0.5}/\mu_5$$

[Method for Preparing Copper Paste]

The copper paste can be prepared by mixing the copper particles, the organic dispersion medium, and components such as the flexibility imparting component, other metal particles, and an arbitrary additive which are added as necessary. For example, after dissolving the flexibility imparting component in an organic solvent, sub-micro copper particles, micro copper particles, the other metal particles, and the arbitrary additive are added to the resultant solution, and a dispersion treatment is performed to prepare the copper paste. Alternatively, the copper paste can be prepared by mixing a solution obtained by dissolving the flexibility imparting component in the organic solvent, a dispersion solution obtained by mixing and dispersing copper particles in a solvent, the other metal particles, and the arbitrary additive. In addition, in a case where dispersibility between the high-boiling-point solvent and the metal particles is not sufficient, the copper paste may be prepared in such a manner that the metal particles are dispersed in the low-boiling-point solvent, the high-boiling-point solvent is added to the resultant solution, and the resultant solution is mixed. In a case where a combination of the surface treatment agent of the metal particles and the high-boiling-point solvent is the above-described preferred combination, the above-described operation is not necessary, and thus metal paste containing a larger amount of high-boiling-point solvent can be prepared in a more efficient manner.

In a case where the copper particles include the sub-micro copper particles and the micro copper particles, a dispersant may be added to the organic solvent or the flexibility imparting component as necessary, a dispersion treatment may be performed after mixing the sub-micro copper particles to the resultant mixture, and a dispersion treatment may be performed after adding the micro copper particles and the other metal particles as necessary to the resultant mixture. A dispersion method and dispersion conditions suitable for dispersion may be different between the sub-micro copper particles and the micro copper particles. Typically, the sub-micro copper particles require stronger dispersion in comparison to the micro copper particles, but the micro copper particles are easy to disperse, low-strength dispersion is sufficient, and deformation occurs in the micro copper particles in strong dispersion. According to the procedure, dispersibility is enhanced, and performance of the copper paste can be improved. An aggregate may be removed by performing a classification operation on a dispersed solution.

In this preparation method, an agitation treatment may be performed after mixing respective components. In the copper paste, a maximum particle size of the dispersed solution may be adjusted through a classification operation. At this time, the maximum particle size of the dispersed solution may be set to 20 μm or less, or 10 μm or less.

The dispersion treatment can be performed by using a disperser or an agitator. For example, an Ishikawa type agitator, a Silverson agitator, a cavitation agitator, a rotation and revolution type agitator, an ultrathin film high-speed rotation type disperser, an ultrasonic disperser, a Raikai mixer, a biaxial kneader, a bead mill, a ball mill, a three-roll mill, a homo-mixer, a planetary mixer, an ultrahigh pressure type disperser, a thin layer shear disperser, and the like are exemplified.

An agitation treatment can be performed by using an agitator. For example, the Ishikawa type agitator, the rotation and revolution type agitator, the Raikai mixer, the biaxial kneader, the three-roll mill, the planetary mixer, and the like are exemplified.

The classification operation can be performed by using, for example, filtration, natural settlement, centrifugation, and the like. Examples of a filtration filter include a water comb, a metal mesh, a metal filter, and a nylon mesh.

[Formation of Pillar Precursor]

In a method according to this embodiment, the pillar precursor can be provided between the first member and the second member by molding the copper paste (copper paste for forming the sintered copper pillar) on the first member in a pillar shape, for example, through printing, and by mounting the second member on the copper paste.

As a copper paste printing method, for example, screen printing, transfer printing, offset printing, a jet printing method, a dispenser, a jet dispenser, a needle dispenser, a comma coater, a slit coater, a die coater, a gravure coater, slit coating, letterpress printing, intaglio printing, gravure printing, stencil printing, soft lithograph, bar coating, an applicator, a particle deposition method, a spray coater, a spin coater, a dip coater, electrodeposition coating, and the like can be used.

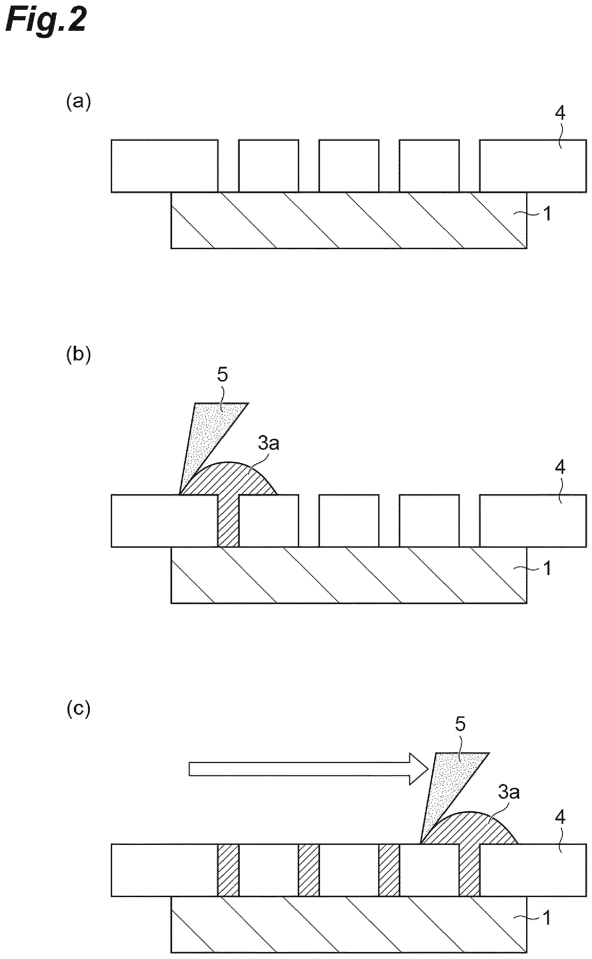

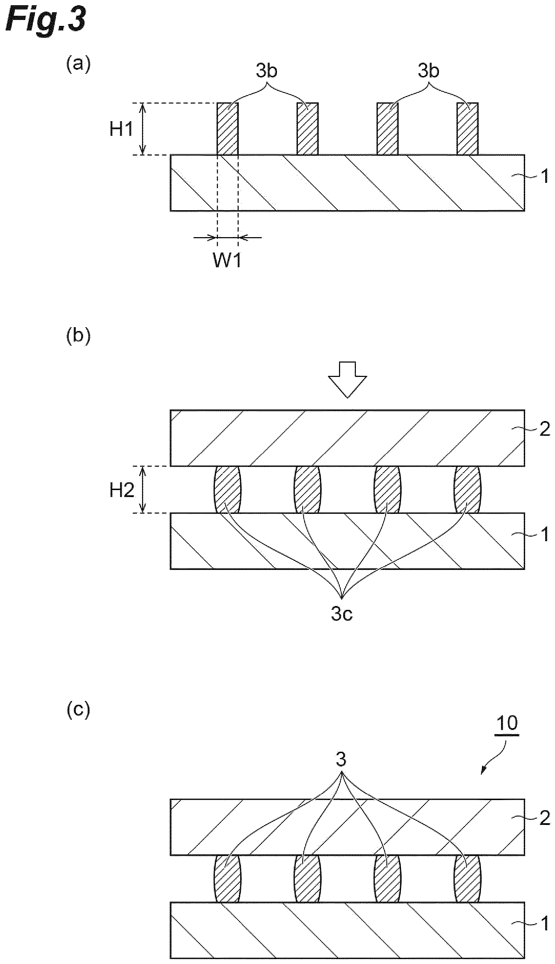

From the viewpoints that a production process is simple, shape stability is likely to be maintained, thick film printing is easy, and the like, it is preferable to mold the copper past into a pillar shape by screen printing or stencil printing. In this case, for example, a metal mask 4 is disposed on the first member 1 (FIG. 2(a)), copper paste 3a is spread by using a squeegee 5, and a hole portion of the metal mask 4 is filled with the copper paste 3a (FIGS. 2(b) and 2(c)). In this manner, copper paste 3b molded into a pillar shape is provided on the first member 1 (FIG. 3(a)).

The metal mask that is used in the screen printing or the stencil printing may have a via diameter of 30 to 200 $\mu$m, or 50 to 100 $\mu$m. Hole may be arranged in a lattice shape, and a pitch interval may be 1 to 500 $\mu$m. A squeegee angle may be 10° to 90°, or 45° to 70°.

A printing height HI may be 5 to 500 $\mu$m, or 10 to 200 $\mu$m. In addition, wetting and spreading W1 from a pillar end after printing may be 100 $\mu$m or less or 50 $\mu$m or less.

A pushed depth (H1-H2) when mounting the second member 2 may be 500 $\mu$m or less, 100 $\mu$m or less, or 50 $\mu$m or less from an uppermost portion of the copper paste molded into the pillar shape. H2 is set in consideration of the height of the sintered copper pillar that is formed, or the pillar precursor.

For example, in a case where the first member and the second member are a micro device and a substrate, respectively, mounting of the second member can be performed by using, for example, a chip mounter, a flip chip bonder, or a carbon or ceramic positioning jig.

In this manner, a pillar precursor 3c is provided between the first member 1 and the second member 2 (FIG. 3(b)).

Next, the pillar precursor 3c disposed between the first member 1 and the second member 2 is sintered to form the sintered copper pillar 3, thereby obtaining the bonded body 10 (FIG. 3(c)).

The pillar precursor may be appropriately dried from the viewpoint of suppressing flowing and occurrence of voids during sintering. A gas atmosphere during drying may be the air, an oxygen-free atmosphere such as nitrogen and a rare gas, or a reducing atmosphere such as hydrogen and formic acid. A drying method may be drying through leaving at room temperature, heating drying, or reduced pressure drying. In the heating drying or the reduced pressure drying, for example, a hot plate, a hot air dryer, a hot air heating furnace, a nitrogen dryer, an infrared dryer, an infrared heating furnace, a far-infrared heating furnace, a microwave heating device, a laser heating device, an electromagnetic heating device, a heater heating device, a steam heating furnace, a hot plate pressing device, or the like can be used. A drying temperature and a drying time may be appropriately adjusted in conformity to the kinds and the amounts of the organic dispersion medium and the flexibility imparting component which are used. For example, the drying temperature and the drying time can be set to 50°C to 180°C, and 30 seconds to 120 minutes, respectively.

Sintering of the pillar precursor can be performed through a heating treatment. In the heating treatment, for example, a hot plate, a hot air dryer, a hot air heating furnace, a nitrogen dryer, an infrared dryer, an infrared heating furnace, a far-infrared heating furnace, a microwave heating device, a laser heating device, an electromagnetic heating device, a heater heating device, a steam heating furnace, or the like can be used.

A gas atmosphere during sintering may be a reducing atmosphere from the viewpoint of removing surface oxides of the copper particles contained in the pillar precursor and adhering surfaces. Examples of the reducing atmosphere include atmospheres in a pure hydrogen gas, in a mixed gas of hydrogen and nitrogen represented as a foaming gas, in nitrogen containing a formic acid gas, in a mixed gas of hydrogen and a rare gas, in a rare gas containing a formic acid gas, and the like.

In this embodiment, in a case where the diameter of the pillar precursor is small (particularly, 200 $\mu$m or less), since formic acid enters the inside of the pillar precursor, copper particles are likely to be reduced, and thus the copper particles can be sufficiently sintered in a reducing atmosphere containing a formic acid gas. In this case, sintering can be performed by using a formic acid reflow furnace, and the degree of sintering can be efficiently improved.

The highest arrival temperature during the heating treatment may be 150°C to 300°C, 170°C to 250°C, or 200°C to 250°C from the viewpoints of causing sintering to proceed sufficiently, reducing a heat damage to members such as the micro device and the substrate, and improving a yield ratio. When the highest arrival temperature is 150°C or higher, sintering tends to proceed sufficiently even when a highest-arrival-temperature retention time is 60 minutes or shorter.

From the viewpoints that the organic dispersion medium and the flexibility imparting component can be sufficiently removed, sintering proceeds sufficiently, and the yield ratio is improved, The highest-arrival-temperature retention time may be 1 to 60 minutes, 1 minute or longer and shorter than 40 minutes, or 1 minute or longer and shorter than 30 minutes.

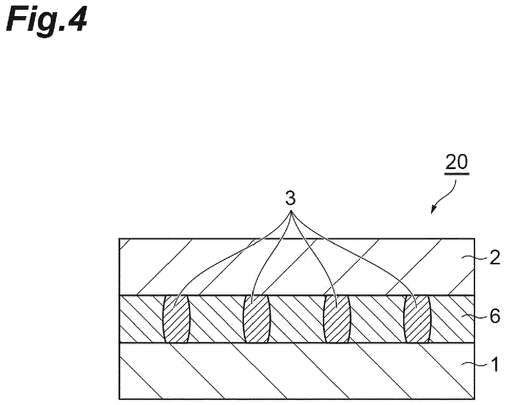

The method for producing the bonded body of this embodiment may further include a step of filling the periphery of the sintered copper pillar with a resin. In this case, a bonded body 20 in which a sealing material 6 is provided between the first member 1 and the second member 2 is obtained (FIG. 4).

As the sealing material, from the viewpoints of protecting a bonded portion from heat, humidity, and impact, and further improving connection reliability, a sealing material for compression mold, a liquid sealing material, a transfer mold sealing material, a sealing material for underfill, and the like can be used.

<Bonding Pillar Equipped Member>

A bonding pillar equipped member of this embodiment is, for example, a bonding pillar equipped member to be bonded to another member through the pillar, which includes a member including a metal layer and a pillar provided on the metal layer, the pillar is composed of sintered copper, the content of copper contained in the pillar is 96% by mass or more on the basis of the total mass of components (however, excluding carbon, oxygen, and nitrogen) constituting the pillar, and a volume ratio of copper in the pillar is 50% by volume or more.

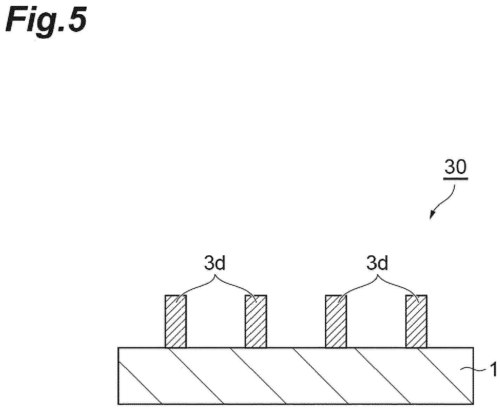

FIG. 5 is a schematic cross-sectional view illustrating an embodiment of the bonding pillar equipped member. A bonding pillar equipped member 30 illustrated in FIG. 5 includes the first member 1, and a pillar 3d provided on the first member 1. The bonding pillar equipped member 30 is bonded to the second member.

For example, the bonding pillar equipped member 30 can be obtained by carrying out the steps up to molding the copper paste on the first member into a pillar shape (FIG. 3(a)), and sintering the copper paste molded into the pillar shape in a similar manner as in the method for producing the bonded body of this embodiment.

Member selection, preparation of copper paste, and molding and sintering of the copper paste can be carried out in a similar manner as in the method for producing the bonded body of this embodiment. This is also true of preferred conditions.

The bonding pillar that is composed of sintered copper and has the above-described configuration can be formed in a shorter time in comparison to electrolytic plating, and thus shortened thermal conductivity and electrical conductivity are excellent, and electromigration is less likely to occur. According to the bonding pillar equipped member including the pillar, it is easy to secure connection reliability of a bonded body obtained by bonding the bonding pillar equipped member to an additional member, and shortening of time in the process of producing the bonded body can be accomplished.

In a case of bonding the bonding pillar equipped member of this embodiment to an additional member through the pillar, copper paste can be used. In this case, since the pillar is bonded with the same kind of sintered copper, an effect of improving electromigration resistance, an effect of suppressing Kirkendall voids, an effect of improving thermal conductivity, and an effect of improving data transmission characteristics are obtained, and as a result, a mounted body excellent in connection reliability and electrical characteristics can be obtained. The copper paste can be set to have the same configuration as in the copper paste for forming the sintered copper pillar of this embodiment.

**Examples**

Hereinafter, the invention will be described in more detail with reference to examples and comparative examples, but the invention is not limited to the following examples.

(Example 1)

Preparation of the copper paste, production and evaluation of the bonded body, and preparation and evaluation of the bonding pillar equipped member were performed by the following method.

[Preparation of Copper Paste]

0.058 g of $\alpha$-terpineol (dispersion medium, manufactured by Wako Pure Chemical Industries, Ltd.), 0.256 g of tributyrin (dispersion medium), 2.189 g of slurry mixture (CH-200 : $\alpha$-terpineol = 91 : 9, in mass ratio), which was prepared in advance, of CH-0200 (sub-micro copper particles, product name, manufactured by Mitsui Mining & Smelting Co., Ltd., 50% volume average particle size: 0.36 $\mu$m, surface treatment agent: lauric acid) and $\alpha$-terpineol (dispersion medium, manufactured by Wako Pure Chemical Industries, Ltd.), 0.493 g of 3L3N (flake-shaped micro copper particles, product name, manufactured by Fukuda Metal Foil & Powder Co., Ltd., volume average particle size: 5.7 $\mu$m), and 0.006 g of zinc (other metal particles, manufactured by Alfa Aesar, product number: 13789) were kneaded with an agate mortar until dry powders disappear, and the resultant mixed solution was transferred to a plastic bottle.

The sealed plastic bottle was agitated at 2000 min$^{-1}$ (2000 revolutions/minute) for two minutes by using a rotation and revolution type agitator (planetary vacuum mixer ARV-310, manufactured by Thinky Corporation). In this manner, Copper Paste 1 was obtained.

[Production of Bonded Body]

A bonded body was formed by the following method by using Copper Paste 1. A stainless metal mask (the number of openings per 7 mm square is 784, and thickness: 50 $\mu$m) in which openings having $\phi$ of 130 $\mu$m are provided in a lattice shape with a pitch interval of 250 $\mu$m was placed on a copper plate (15 mm square, thickness: 0.3 mm) as the first member, the copper paste was applied with stencil printing using a metal squeegee. After application of the copper paste, the copper paste was left as is at room temperature for predetermined time, an Ni-plated Si chip (3 mm square, thickness: 0.15 mm) as the second member was placed on the pillar-shaped copper paste provided on a substrate, and pushing was performed from an upper side of the Si chip by 10 $\mu$m by using a spencer equipped pushing jig. The predetermined time was set to one hour, two hours, and three hours. Then, the resultant laminated body (the copper plate/the pillar precursor/the Si chip) was put in a hydrogen sintering furnace (a reducing atmosphere, hydrogen: 100%), a temperature was raised up to 225°C at a temperature-raising rate of 7.5°C/minute, and the laminated body was maintained at 225°C for 60 minutes. Then, the laminated body was cooled up to 200°C for five minutes and was maintained at 200°C for five minutes, and then, the laminated body was rapidly cooled to room temperature, thereby obtaining Bonded Body 1 (in which the Si chip was mounted after leaving for one hour), Bonded Body 2 (in which the Si chip was mounted after leaving for two hours), and Bonded Body 3 (in which the Si chip was mounted after leaving for three hours).

[Bonding State Evaluation 1]

Each of Bonded Bodies 1 to 3 was turned over, slight vibration was applied thereto to perform a simple evaluation for a bonding property, and a bonding state was evaluated on the basis of the following determination criteria. Results are shown in Table 1.

[Determination Criteria]

A: The Si chip in Bonded Bodies 1 to 3 was not peeled off, and existed on the copper substrate.
B: The Si chip in Bonded Bodies 1 and 2 was not peeled off, but the Si chip in Bonded Body 3 was peeled off.
C: The Si chip in Bonded Body 1 was not peeled off, but the Si chip in Bonded Bodies 2 and 3 was peeled off.
D: The Si chip in Bonded Bodies 1 to 3 was peeled off.

[Bonding State Evaluation 2]

Each of the bonded bodies obtained in Evaluation 1 was put into a cup and was fixed by a sample clip (Samplklip I, manufactured by Buehler), an epoxy cast resin (product name: Epomount, manufactured by Refine Tec Ltd.) was poured to the periphery of the bonded body until the entirety of the bonded body was embedded, and the resultant member was left to stand still in a vacuum desiccator and was defoamed through depressurization for one minute.

Then, the resultant member was left as is at room temperature (25°C) for 10 hours to cure the epoxy cast resin, thereby obtaining a cast sample. The cast sample was cut in the vicinity of a cross-section of the cast sample to be observed by using a resinoid cutting wheel equipped Refine Saw Excel (manufactured by Refine Tec Ltd.). Then, the cross-section was polished by a polishing device (Refine Polisher HV, manufactured by Refine Tec Ltd.) equipped with water-resistant polishing paper (Carbomac Paper, manufactured by Refine Tec Ltd.) to expose a bonding portion of the sintered copper pillar. In addition, an end portion extruding from the mask was cut in a CP mode by using an ion milling device "IM4000" (manufactured by Hitachi, Ltd.) to prepare an observation sample.

The cross-section of the bonding portion in the observation sample was observed at an application voltage of 15 kV and various magnifications. In a bonded body in which the Si chip is not peeled off, it was confirmed that the sintered copper pillar and an adherend are metal-bonded.

(Examples 2 and 3)

Copper Paste 2 and Copper Paste 3 were obtained in a similar manner as in Example 1 except that blending amounts of respective components were adjusted so that the content of each of the components becomes a value shown in Table 1. Preparation and evaluation of a bonded body were performed in a similar manner as in Example 1 except that the obtained Copper Paste 2 or 3 was used. Results are shown in Table 1.

(Examples 4 and 5)

Copper Paste 4 and Copper Paste 5 were obtained in a similar manner as in Example 1 except that isobornyl cyclohexanol (Terusolve MTPH, manufactured by Nippon Terpene Chemicals, Inc.) was used as the dispersion medium, and blending amounts of respective components were adjusted so that the content of each of the components becomes a value shown in Table 1. Preparation and evaluation of a bonded body were performed in a similar manner as in Example 1 except that the obtained Copper Paste 4 or 5 was used. Results are shown in Table 1.

(Example 6)

0.1772 g of octyl octanoate (dispersion medium, manufactured by Sigma-Aldrich JP K.K.), 2.0308 g of slurry mixture (CH-200 : $\alpha$-terpineol : butyl stearate = 91 : 0.9 : 8.1, in mass ratio), which was prepared in advance, of CH-0200 (sub-micro copper particles, product name, manufactured by Mitsui Mining & Smelting Co., Ltd., 50% volume average particle size: 0.36 $\mu$m), $\alpha$-terpineol (dispersion medium, manufactured by Wako Pure Chemical Industries, Ltd.), and butyl stearate (dispersion medium, manufactured by Wako Pure Chemical Industries, Ltd.), 0.7867 g of 3L3N (flake-shaped micro copper particles, product name, manufactured by Fukuda Metal Foil & Powder Co., Ltd., volume average particle size: 5.7 $\mu$m), and 0.006 g of zinc (other metal particles, manufactured by Alfa Aesar, product name: 13789) were kneaded with an agate mortar until dry powders disappear, and the resultant mixed solution was transferred to a plastic bottle.

The sealed plastic bottle was agitated at 2000 min$^{-1}$ (2000 revolutions/minute) for two minutes by using a rotation and revolution type agitator (planetary vacuum mixer ARV-310, manufactured by Thinky Corporation). In this manner, Copper Paste 6 was obtained. Preparation and evaluation of a bonded body were performed in a similar manner as in Example 1 except that the obtained Copper Paste 6 was used. Results are shown in Table 1.

(Examples 7 to 11)

Copper Paste 7 to Copper Paste 11 were obtained in a similar manner as in Example 6 except that blending amounts of respective components were adjusted so that the content of each of the components becomes a value shown in Table 2. Preparation and evaluation of a bonded body were performed in a similar manner as in Example 1 except that each of the obtained Copper Paste 7 to the obtained Copper Paste 11 was used. Results are shown in Table 2.

(Comparative Examples 1 to 3)

Copper Paste 12 to Copper Paste 14 were obtained in a similar manner as in Example 1 except that blending amounts of respective components were adjusted so that the content of each of the components becomes a value shown in Table 3. Note that, $\alpha$-terpineol used in Comparative Example 2 was only $\alpha$-terpineol contained in the slurry mixture, and $\alpha$-terpineol was not added during kneading. Preparation and evaluation of a bonded body were performed in a similar manner as in Example 1 except that each of the obtained Copper Paste 12 to the obtained Copper Paste 14 was used. Results are shown in Table 3.

[Table 1]

| | | Example 1 | | Example 2 | | Example 3 | | Example 4 | | Example 5 | |
|---|---|---|---|---|---|---|---|---|---|---|---|
| | | (g) | (% by mass) | (g) | (% by mass) | (g) | (% by mass) | (g) | (% by mass) | (g) | (% by mass) |
| Metal particles | CH-200 | 1.99199 | 66.4 | 1.99199 | 66.4 | 1.696422 | 56.2 | 1.743014 | 58.1 | 1.743014 | 58.08 |
| | 3L3N | 0.493 | 16.4 | 0.493 | 16.4 | 0.7152 | 23.7 | 0.742 | 24.7 | 0.742 | 24.73 |
| | Zinc | 0.006 | 0.2 | 0.006 | 0.2 | 0.006 | 0.2 | 0.006 | 0.2 | 0.006 | 0.20 |
| Low-boiling-point solvent | $\alpha$-Terpineol | 0.25501 | 8.5 | 0.20401 | 6.8 | 0.181578 | 6.0 | 0.254986 | 8.5 | 0.254986 | 8.50 |
| High-boiling-point solvent | Tributyrin | 0.256 | 8.5 | 0.306 | 10.2 | 0.42 | 13.9 | 0.1466 | 4.9 | 0.102 | 3.40 |
| | Isobornyl cyclohexanol | - | - | - | - | - | - | 0.1084 | 3.6 | 0.153 | 5.10 |
| Content of high-boiling-point solvent | In organic dispersion medium (% by mass) | 50.1 | | 60.0 | | 69.8 | | 50.0 | | 50.0 | |
| | In copper paste (% by mass) | 8.5 | | 10.2 | | 13.9 | | 8.5 | | 8.5 | |
| Evaluation | | B | | B | | A | | A | | A | |

[Table 2]

| | | Example 6 | | Example 7 | | Example 8 | | Example 9 | | Example 10 | | Example 11 | |
|---|---|---|---|---|---|---|---|---|---|---|---|---|---|---|
| | | (g) | (% by mass) | (g) | (% by mass) | (g) | (% by mass) | (g) | (% by mass) | (g) | (% by mass) | (g) | (% by mass) |
| Metal particles | CH-200 | 1.848028 | 61.6 | 1.953042 | 65.1 | 1.743014 | 58.1 | 1.680042 | 56.0 | 1.470014 | 49.0 | 2.112019 | 70.4 |
| | 3L3N | 0.7867 | 26.2 | 0.8314 | 27.7 | 0.742 | 24.7 | 0.7152 | 23.8 | 0.6258 | 20.8 | 0.5227 | 17.4 |
| | Zinc | 0.006 | 0.2 | 0.006 | 0.2 | 0.006 | 0.2 | 0.006 | 0.2 | 0.006 | 0.2 | 0.006 | 0.2 |
| Low-boiling-point solvent | α-Terpineol | 0.0182772 | 0.6 | 0.0193158 | 0.6 | 0.0172386 | 0.6 | 0.0166158 | 0.6 | 0.0145386 | 0.5 | 0.0208881 | 0.7 |
| High-boiling-point solvent | Butyl stearate | 0.1644948 | 5.5 | 0.1738422 | 5.8 | 0.1551474 | 5.2 | 0.1495422 | 5.0 | 0.1308474 | 4.4 | 0.1879929 | 6.3 |
| | Octyl octanoate | 0.1772 | 5.9 | 0.0168 | 0.6 | 0.3376 | 11.2 | 0.4338 | 14.5 | 0.7546 | 25.1 | 0.1511 | 5.0 |
| Content of high-boiling-point solvent | In organic dispersion medium (% by mass) | 94.9 | | 90.8 | | 96.6 | | 97.2 | | 98.4 | | 94.2 | |
| | In copper paste (% by mass) | 11.4 | | 6.4 | | 16.4 | | 19.4 | | 29.5 | | 11.3 | |
| Evaluation | | A | | B | | A | | A | | B | | A | |

EP 4 023 362 A1

18

[Table 3]

| | | Comparative Example 1 | | Comparative Example 2 | | Comparative Example 3 | |
|---|---|---|---|---|---|---|---|
| | | (g) | (% by mass) | (g) | (% by mass) | (g) | (% by mass) |
| Metal particles | CH-200 | 2.112019 | 70.4 | 2.112019 | 70.4 | 1.99199 | 66.4 |
| | 3L3N | 0.5227 | 17.4 | 0.5227 | 17.4 | 0.493 | 16.4 |
| | Zinc | 0.006 | 0.2 | 0.006 | 0.2 | 0.006 | 0.2 |
| Low-boiling-point solvent | α-Terpineol | 0.251981 | 8.4 | 0.208881 | 7.0 | 0.35701 | 11.9 |
| High-boiling-point solvent | Tributyrin | 0.108 | 3.6 | 0.1512 | 5.0 | 0.153 | 5.1 |
| Content of high-boiling-point solvent | In organic dispersion medium (% by mass) | 30.0 | | 42.0 | | 30.0 | |
| | In copper paste (% bv mass) | 3.6 | | 5.0 | | 5.1 | |
| Evaluation | | C | | C | | C | |

**Reference Signs List**

1: first member, 2: second member, 3: sintered copper pillar, 3a: copper paste, 4: metal mask, 5: squeegee, 10, 20: bonded body, 30: bonding pillar equipped member.

**Claims**

1. Copper paste for forming sintered copper pillar that bonds members to each other, comprising:

  metal particles; and
  an organic dispersion medium,
  wherein the metal particles comprise copper particles, and
  the organic dispersion medium comprises a high-boiling-point solvent having a boiling point of 280°C or higher in an amount of 50% by mass to 99% by mass on the basis of a total mass of the organic dispersion medium.

2. The copper paste according to claim 1,
  wherein the amount of the high-boiling-point solvent is 5% by mass to 30% by mass on the basis of the total mass of the copper paste.

3. The copper paste according to claim 1 or 2,
  wherein the organic dispersion medium comprises two or more kinds of the high-boiling-point solvents.

4. The copper paste according to any one of claims 1 to 3, comprising at least one kind selected from the group consisting of isobornyl cyclohexanol and butyl stearate as the high-boiling-point solvent.

5. A method for producing a bonded body including a first member, a second member, and a sintered copper pillar that bonds the first member and the second member to each other, the method comprising the steps of:

  molding the copper paste according to any one of claims 1 to 4 in a pillar shape on the first member, and then mounting the second member to provide a pillar precursor between the first member and the second member; and sintering the pillar precursor to form the sintered copper pillar.

*Fig.1*

# *Fig.2*

(a)

(b)

(c)

# Fig.3

(a)

(b)

(c)

**Fig.4**

**Fig.5**

## INTERNATIONAL SEARCH REPORT

| | International application No. |
|---|---|
| | PCT/JP2020/035564 |

A. CLASSIFICATION OF SUBJECT MATTER

B22F 1/00(2006.01)i; B22F 7/08(2006.01)i; B82Y 30/00(2011.01)i; B82Y 40/00(2011.01)i; H01B 1/22(2006.01)i
FI: H01B1/22 A; B22F7/08 C; B22F1/00 L; B82Y40/00; B82Y30/00

According to International Patent Classification (IPC) or to both national classification and IPC

B. FIELDS SEARCHED

Minimum documentation searched (classification system followed by classification symbols)
B22F1/00; B22F7/08; B82Y30/00; B82Y40/00; H01B1/22

Documentation searched other than minimum documentation to the extent that such documents are included in the fields searched

| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | WO 2019/093427 A1 (HITACHI CHEMICAL CO., LTD.) 16 May 2019 (2019-05-16) paragraphs [0027]-[0066], [0112]-[0113], fig. 2 | 1-5 |
| Y | JP 2003-110240 A (SUMITOMO METAL MINING CO., LTD.) 11 April 2003 (2003-04-11) paragraph [0019] | 1-5 |
| Y | JP 2016-115846 A (MITSUBISHI MATERIALS CORP.) 23 June 2016 (2016-06-23) paragraphs [0045]-[0053], [0058] | 1-5 |

☐ Further documents are listed in the continuation of Box C.      ☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 23 October 2020 (23.10.2020) | 02 November 2020 (02.11.2020) |

| Name and mailing address of the ISA/ | Authorized officer |
|---|---|
| Japan Patent Office 3-4-3, Kasumigaseki, Chiyoda-ku, Tokyo 100-8915, Japan | Telephone No. |

Form PCT/ISA/210 (second sheet) (January 2015)

| Patent Documents referred in the Report | Publication Date | Patent Family | Publication Date |
|---|---|---|---|
| WO 2019/093427 A1 | 16 May 2019 | EP 3709339 A1 paragraphs [0027]-[0066], [0112]-[0113], fig. 2 | |
| JP 2003-110240 A | 11 Apr. 2003 | (Family: none) | |
| JP 2016-115846 A | 23 Jun. 2016 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20160351529